# EUROPÄISCHE PATENTSCHRIFT

(11) **EP 0 468 267 B1**
(45) Veröffentlichungstag und Bekanntmachung des Hinweises auf die Patenterteilung: **13.04.1994**
(21) Anmeldenummer: 91111348.8
(22) Anmeldetag: 08.07.1991
(51) Int. Cl.: H05K 13/06, B23K 11/00

(54) **Verlegewerkzeug zum Verlegen einer Änderungsverdrahtung bei Leiterplatten, sowie Verfahren zum Verlegen der Änderungsverdrahtung**
Laying tool for laying modification wires on printed circuit boards and method therefor
Outil déposé pour poser des fils de modification sur des circuits imprimés et méthode associée

(30) Priorität: 23.07.1990 DE 4023389
(43) Veröffentlichungstag der Anmeldung: 29.01.1992
(73) Patentinhaber: Siemens Nixdorf Informationssysteme Aktiengesellschaft, 33102 Paderborn (DE)
(72) Erfinder: Thorwarth, Rüdiger, W-8019 Glonn (DE)
(74) Vertreter: Fuchs, Franz-Josef, Dr.-Ing.

(56) Entgegenhaltungen:
- FR-A- 2 526 624
- US-A- 3 553 813
- US-A- 3 673 681

## Beschreibung

Die Erfindung betrifft ein Verlegewerkzeug zum Verlegen einer Änderungsverdrahtung bei Leiterplatten, wie z.B. Plattern für Einrichtungen der Datentechnik, mit auf zugehörigen Lötflecken aufgelöteten Kontaktstiften.

Sie betrifft ferner ein Verfahren zum Verlegen einer Änderungsverdrahtung bei Leiterplatten, wie z.B. Plattern für Einrichtungen der Datentechnik auf zugehörigen Lötflecken aufgelöteten Kontaktstiften, sehe z.B. US-A- 3 553 813.

Bei Leiterplatten mit aufgelöteten Kontaktstiftfeldern, wie z.B. bei Plattern für Einrichtungen der Datentechnik sollen häufig zusätzliche elektrische Verbindungen durch Drähte hergestellt werden. Diese Drähte werden immer paarweise verlegt und sollen an den dafür vorgesehenen Kontaktstellen des jeweiligen Stiftlötfleckes (Stiftpads) aufgelötet werden. Die Lötflecken sind ca. 400 x 400 Mikrometer groß und haben einen Abstand von 600 Mikrometern.

Aufgabe der vorliegenden Erfindung ist es daher, ein Werkzeug zur Verlegung einer Änderungsverdrahtung bei derartigen Leiterplatten zu schaffen und ein Verfahren hierzu anzugeben, wobei der Wellenwiderstand der verdrallten Drähte einen definierten vorgegebenen Wert einhalten soll.

Zur Lösung dieser Aufgabe wird das Verlegewerkzeug derart ausgebildet, daß es aus einem Schrittmotor mit auf beiden Seiten vorstehender Hohlwelle besteht, an deren rückseitigem Ende an einem ersten Flansch Drahtrollen befestigt sind und an deren vorderseitigen Motorwellenende an einem zweiten Flansch eine Düse mit einer eingepreßten Kanüle angeordnet ist, wobei in der Kanüle ein paßgenauer Stift mit Führungsrillen mit den eingefädelten Drähten der Drahtspulen angeordnet ist, der über ein Kupplungsstück mit dem vorderseitigen Motorwellenende verbunden ist.

Bei der Verlegung der Änderungsverdrahtung wird dabei so verfahren, daß zunächst das Verlegewerkzeug mit der Drahtkanüle auf die Leiterplattenebene abgesenkt wird und durch schrittweises Drehen der Motorwelle die Drähte auf die zugehörigen Lötflecken ausgerichtet werden, daß anschließend Lötbügel auf die Anfangskontaktstellen von Drähten und Lötflecken abgesenkt und durch Beaufschlagen eines ersten elektrischen Impulses auf die Lötbügel die Lackisolation der Drähte abgedampft und durch einen zweiten elektrischen Impuls die Drähte an den Lötflecken festgelötet werden, daß anschließend der Verlegekopf des Verlegewerkzeuges unter einer Schwenkung von 45 ° Grad und gleichzeitigem schrittweisen Drehen der Motorwelle aus dem Stiftfeld herausgefahren und durch synchrones Verschieben der Leiterplatte bis zur Endkontaktstelle und Absenken des Verlegekopfes des Verlegewerkzeuges auf die Leiterplatte die Endkontaktstelle erreicht wird, daß anschließend die Lötbügel ebenfalls aus dem Stiftfeld herausgefahren und an der Endkontaktstelle wieder eingefahren werden und dort wiederum das Abdampfen der Lackisolierung und das Festlöten der Drähte auf den Lötflecken erfolgt, daß danach ähnlich wie die Lötbügel ausgebildete Heizbügel in geringem Abstand hinter den Lötbügeln abgesenkt und die Isolation der Drähte an der Kontaktzone mit dem Heizbügel ebenfalls abgedampft werden, daß anschließend der Übergangswiderstand zwischen den Lötbügeln und den Heizbügeln gemessen und die Drähte wenn der vorgegebene Kontaktwiderstand gemessen wird mit Hilfe eines an die Heizbügel angelegten weiteren elektrischen Impulses abgetrennt werden und daß dann Lötbügel, Heizbügel und Verlegekopf des Verlegewerkzeuges aus der Leiterplattenebene ausgeführt werden.

Durch dieses Verfahren lassen sich Änderungsverdrahtungen auf Leiterplatten, wie z.B. Plattern, für Einrichtungen der Datentechnik, die mit aufgelöteten Kontaktstiftfeldern versehen sind in einfacher Weise durchführen, wobei durch das Verdrallen der Drähte mit bestimmter Schlaglänge der jeweils geforderte Wellenwiderstand in einfacher Weise hergestellt werden kann. Das dazugehörige Werkzeug ist einfach aufgebaut und ermöglicht das Verlegen auch von Drähten mit sehr kleinen Durchmessern.

Anhand der Ausführungsbeispiele nach den Figuren 1 bis 3 wird die Erfindung näher erläutert. Es zeigen
- FIG 1: den Verlegekopf des Verlegewerkzeuges,
- FIG 2: das vordere Ende des Verlegekopfes mit der Kanüle in der Lötstellung beim Anfangskontakt,
- FIG 3: das vordere Ende des Verlegekopfes mit der Kanüle an der Endkontaktstelle.

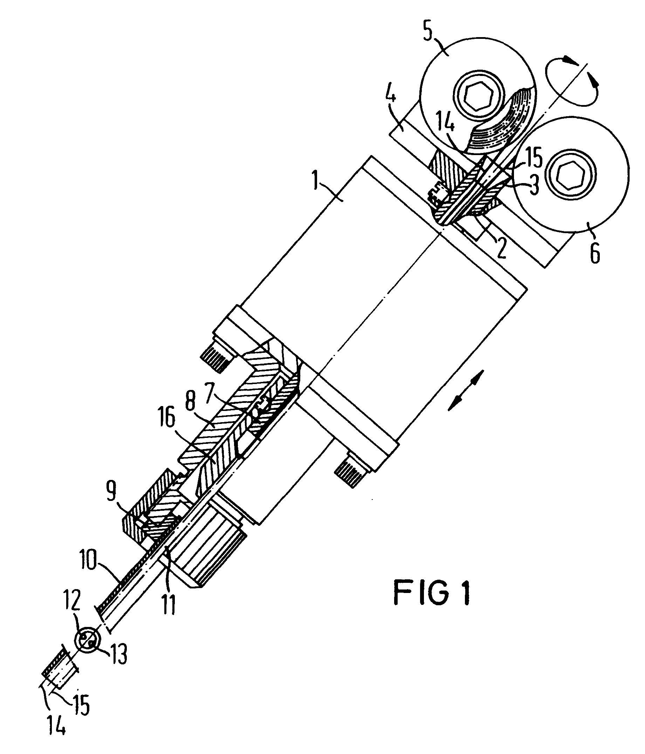

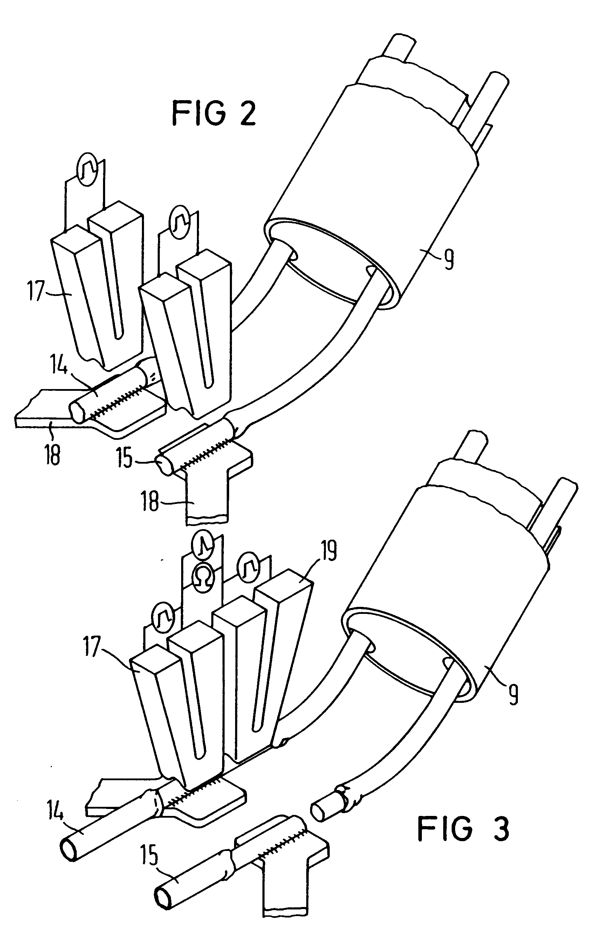

Das Verlegen und Verdrallen der Drähte geschieht mit nur einem Werkzeug. Das Verlegewerkzeug nach FIG 1 besteht aus dem Schrittmotor 1 mit durchgehender hohler Welle 2. Auf dem rückseitigen Wellenende 3 befindet sich ein Flansch 4 mit den beiden Drahtspulen 5, 6 für Signal- und Massedraht.

Auf dem gegebenüberliegenden Motorflansch ist eine Düse 9 mit einer eingepreßten Kanüle 10 befestigt. In der Kanüle 10 läuft paßgenau ein Stift 11 mit zwei durchgehenden Führungsrillen 12, 13 von z.B. 100 µm mit einem Abstand von 600 µm. Der Stift 11 ist über ein Kupplungsstück 16 mit dem zweiten Motorwellenende 7 verbunden, d.h. Stift 11 und Kanüle 10 sind koaxial aufgebaut, wobei Stift 11 und Drahtspulen 5, 6 gemeinsam von der Motorwelle rotierend angetrieben werden. Die Drähte 14, 15 werden von den Drahtspulen 5, 6 abgerollt, durch die Motorwelle geführt und treten durch die Führungsrillen 12, 13 des Stiftes 11 parallel auf z.B. 600 µm Abstand ausgerichtet, aus dem Kanülenende heraus. Zur Herstellung der Verbindung mit der Leiterplatte fährt die Drahtkanüle 10 bis auf die Ebene der Leiterplatte, wobei die beiden Drähte zwischen Anfangs- und Endpunkt der Drahtverlegung von dieser geführt werden.

Die aus dem Kanülenende überstehenden Drahtenden werden durch schrittweise Drehung der Motorwelle entsprechend ihrer Zugehörigkeit auf das Signal- und Massepad ausgerichtet.

Das Ankontaktieren der Drahtenden geschieht durch Lötbügel, wie in FIG 2 gezeigt, wobei mittels einer elektrischen Impulssteuerung zuerst die Lackisolation der Drahtenden abgedampft und anschließend die Lötverbindung mit dem Lötflecken 18 (Pad) hergestellt wird. Durch Rückfahren des Verlegekopfes unter 45 ° aus dem Stiftfeld und gleichzeitiges Drehen der Motorwelle mit definierter Umdrehung pro Längeneinheit werden die Drähte 14, 15 abgespult und auf den gewünschten Wellenwiderstand verdrallt.

Durch synchrones Verfahren der Leiterplatte und des Verlegekopfes in Richtung Leiterplatte wird die abgespulte und verdrallte Drahtlänge auf die Leiterplattenebene verlegt. Die bis dahin abgesenkten Lötbügel 17, die während des Verdrallvorganges die Lötstelle mechanisch entlasten, fahren danach aus dem Stiftfeld. Beim Auflöten des Endkontaktes wird, wie in FIG 3 dargestellt, wie beim Startkontakt verfahren. Das Lötbügelpaar 17 isoliert die Drähte 14, 15 ab und kontaktiert sie auf den Pads 18.

Um die Drähte nach der Lötstelle abzutrennen, setzt ein Heizbügelpaar 19 in geringem Abstand von den Lötbügeln 17 auf den Drähten auf. Mit einem geregelten Stromimpuls wird nur die Lackisolation im Bereich der Kontaktzone des Heizbügels 19 abgedampft und dann der Übergangswiderstand zwischen dem ersten und zweiten Bügel über den darunterliegenden Draht gemessen.

Bei gutem Kontakt wird ein Stromimpuls ausgelöst, der den Draht 14 zwischen den Bügeln 17, 18 elektrisch trennt. Das gleiche geschieht mit dem zweiten Draht 15. Nach dem Trennvorgang fahren Lötbügel 17, Heizbügel 19 und Verlegekopf aus der Leiterplattenebene heraus. Die aus der Verlegekanüle 10 überstehenden Drahtenden sind wieder Startkontakt für einen nächsten Verdrahtungsvorgang.

Die Steuervorrichtungen für den Verlegekopf des Verlegewerkzeuges sind aus Übersichtlichkeitsgründen weggelassen, da sie lediglich die allgemein bekannten üblichen Steuermechanismen enthalten.

## Patentansprüche

1. Verlegewerkzeug zum Verlegen einer Änderungsverdrahtung bei Leiterplatten, wie wie z.B. Plattern für Einrichtungen der Datentechnik, mit auf zugehörigen Lötflecken aufgelöteten Kontaktstiften,
**gekennzeichnet durch** einen Schrittmotor (1) mit auf beiden Seiten vorstehender Hohlwelle (2) an deren rückseitigem Ende (3) an einem ersten Flansch (4) Drahtrollen (5, 6) befestigt sind und an deren vorderseitigem Motorwellenende (7) an einem zweiten Flansch (8) eine Düse (9) mit einer eingepreßten Kanüle (10) angeordnet ist, wobei in der Kanüle (10) ein paßgenauer Stift (11) mit Führungsrillen (12, 13) mit den eingefädelten Drähten (14, 15) der Drahtspulen angeordnet ist, der über ein Kupplungsstück (16) mit dem vorderseitigen Motorwellenende verbunden ist.

2. Verfahren zum Verlegen einer Änderungsverdrahtung bei Leiterplatten, wie z.B. Plattern für Einrichtungen der Datentechnik auf zugehörigen Lötflecken aufgelöteten Kontaktstiften, **dadurch gekennzeichnet**, daß zunächst das Verlegewerkzeug mit der Drahtkanüle (9) auf die Leiterplattenebene abgesenkt wird und durch schrittweises Drehen der Motorwelle die Drähte (14, 15) auf die zugehörigen Lötflecken (18) ausgerichtet werden, daß anschließend Lötbügel (17) auf die Anfangskontaktstellen von Drähten (14, 15) und Lötflecken (18) abgesenkt und durch Beaufschlagen eines ersten elektrischen Impulses auf die Lötbügel (17) die Lackisolation der Drähte (14, 15) abgedampft und durch einen zweiten elektrischen Impuls die Drähte (14, 15) an den Lötflecken (18) festgelötet werden, daß anschließend der Verlegekopf des Verlegewerkzeuges unter einer Schwenkung von 45 ° Grad und gleichzeitigem schrittweisen Drehen der Motorwelle (2) aus dem Stiftfeld herausgefahren und durch synchrones Verschieben der Leiterplatte bis zur Endkontaktstelle und Absenken des Verlegekopfes des Verlegewerkzeuges auf die Leiterplatte die Endkontaktstelle erreicht wird, daß anschließend die Lötbügel (17) ebenfalls aus dem Stiftfeld herausgefahren und an der Endkontaktstelle wieder eingefahren werden und dort wiederum das Abdampfen der Lackisolierung und das Festlöten der Drähte (14, 15) auf den Lötflecken (18) erfolgt, daß danach ähnlich wie die Lötbügel (17) ausgebildete Heizbügel (19) in geringem Abstand hinter den Lötbügeln abgesenkt und die Isolation der Drähte (14, 15) an der Kontaktzone mit dem Heizbügel (19) ebenfalls abgedampft werden, daß anschließend der Übergangswiderstand zwischen den Lötbügeln (17) und den Heizbügeln (19) gemessen und die Drähte wenn der vorgegebene Kontaktwiderstand gemessen wird mit Hilfe eines an die Heizbügel (19) angelegten weiteren elektrischen Impulses abgetrennt werden und daß dann Lötbügel (17), Heizbügel (19) und Verlegekopf des Verlegewerkzeuges aus der Leiterplattenebene ausgeführt werden.

## Claims

1. Laying tool for laying modification wiring in the case of printed-circuit boards such as, for example, boards for devices of data technology, having contact pins which are soldered on associated solder pads, characterized by a stepping motor (1) having a hollow shaft (2), which projects on both sides, on whose rear end (3) wire rollers (5, 6) are mounted on a first flange (4), and on whose front motor-shaft end (7) a nozzle (9) having a pressed-in channel (10) is arranged on a second flange (8), an accurately fitting pin (11) having guide grooves (12, 13) with the threaded-in wires (14, 15) of the wire coils being arranged in the channel (10), which pin (11) is connected via a coupling piece (16) to the front motor-shaft end.

2. Method for laying modification wiring in the case of printed-circuit boards, such as, for example, boards for devices of data technology having contact pins soldered onto associated solder pads, characterized in that the laying tool is initially lowered with the wire channel (9) onto the printed-circuit board plane and the wires (14, 15) are aligned with the associated solder pads (18) by step-by-step rotation of the motor shaft, in that soldering irons (17) are subsequently lowered onto the initial contact points of wires (14, 15) and solder pads (18) and the varnish insulation of the wires (14, 15) is vaporised by application of a first electrical pulse onto the soldering irons (17), and the wires (14, 15) are firmly soldered to the solder pads (18) by a second electrical pulse, in that the laying head of the laying tool is subsequently moved out of the pin area with a pivoting movement of 45° and simultaneous step-by-step rotation of the motor shaft (2), and the final contact point is reached by synchronous displacement of the printed-circuit board as far as the final contact point and lowering of the laying head of the laying tool onto the printed-circuit board, in that the soldering irons (17) are subsequently likewise moved out of the pin area and are moved in again at the final contact point, and the vaporisation of the varnish insulation and firm soldering of the wires (14, 15) to the solder pads (18) is in turn carried out there, in that, thereafter, heating irons (19), which are of similar construction to the soldering irons (17) are lowered a short distance behind the soldering irons, and the insulation of the wires (14, 15) is likewise vaporised on the contact zone by means of the heating iron (19) in that the contact resistance between the soldering irons (17) and the heating irons (19) is subsequently measured and, if the predetermined contact resistance is measured, the wires are cut off with the aid of a further electrical pulse applied to the heating irons (19) and in that the soldering irons (17), heating irons (19) and laying head of the laying tool are then moved out of the printed-circuit board plane.

## Revendications

1. Outil de pose d'un câblage de modification sur des plaquettes à circuits imprimés, comme par exemple des disques pour des dispositifs de la technique de transmission des données, comportant des broches de contact fixées par brasage sur des plots de brasage associés,
caractérisé par un moteur pas-à-pas (1) comportant un arbre creux (2) qui fait saillie des deux côtés et sur le bout arrière (3) duquel sont fixés, sur une première bride (4), des rouleaux de fil (5, 6), tandis que sur le bout avant (7) de l'arbre du moteur, est montée, sur une seconde bride (8), une buse (9) ayant une canule qui est insérée à force (10) et dans laquelle est disposée une broche (11) ajustée de façon précise et comportant des rainures de guidage (12, 13) dans lesquelles sont enfilés des fils (14, 15) des bobines de fil et raccordée au bout avant de l'arbre du moteur par l'intermédiaire d'une pièce d'accouplement (16).

2. Procédé pour la pose d'un câblage de modification sur des plaquettes à circuits imprimés, comme par exemple des disques pour des dispositifs de la technique de transmission des données, comportant des broches de contact fixées par brasage sur des plots de brasage associés, caractérisé par le fait que tout d'abord on abaisse l'outil de pose muni de la canule à fils (9) en direction du plan de la plaquette à circuits imprimés et qu'au moyen d'une rotation pas-à-pas de l'arbre du moteur, on aligne les fils (14, 15) sur les plots de brasage (18) associés, qu'ensuite on abaisse les étriers de brasage (17) sur les zones de contact initial des fils (14, 15) et des plots de brasage (18) et qu'en appliquant une première impulsion électrique aux étriers de brasage (17), on évapore le vernis isolant des fils (14, 15) et, par une seconde impulsion électrique, on fixe par brasage les fils (14, 15) aux plots de brasage (18), qu'ensuite on fait sortir la tête de pose de l'outil de pose hors de la zone de la broche par un basculement de 45° et par une rotation pas-à-pas simultanée de l'arbre (2) du moteur, et par un déplacement en synchronisme de la plaquette à circuits imprimés jusqu'à la zone de contact finale et par abaissement de la tête de pose de l'outil de pose sur la plaquette à circuits imprimés, on atteint la zone de contact finale, qu'ensuite on retire également les étriers de brasage (17) de la zone de la broche et qu'on l'approche à nouveau de la zone de contact finale et qu'à nouveau on effectue en cet endroit l'évaporation du vernis isolant et la fixation par brasage des fils (14, 15) sur les plots de brasage (18), qu'ensuite on abaisse des étriers de chauffage (19), constitués de la même manière que les étriers de brasage (17), à une faible distance derrière les étriers de brasage et qu'on évapore également l'isolant des fils (14, 15) dans la zone de contact à l'aide des étriers de chauffage (19), qu'ensuite on mesure la résistance de jonction entre les étriers de brasage (17) et les étriers de chauffage (19) et qu'on sectionne les fils, lorsque la résistance de contact prédéterminée est mesurée, à l'aide d'une autre impulsion électrique appliquée aux étriers de chauffage (19), et qu'ensuite on écarte du plan de la plaquette à circuits imprimés les étriers de brasage (17), les étriers de chauffage (19) et la tête de pose de l'outil de pose.
